# EUROPEAN PATENT APPLICATION

(11) **EP 2 053 653 A1**
(43) Date of publication of application: **29.04.2009**
(21) Application number: 08157793.4
(22) Date of filing: 06.06.2008
(51) Int. Cl.: H01L 21/8234, H01L 21/8238, H01L 29/51, H01L 27/088, H01L 27/092

(54) **Dual work function semiconductor device and method for manufacturing the same**

(30) Priority: 24.10.2007 US 982332 P
(71) Applicant: INTERUNIVERSITAIR MICROELEKTRONICA CENTRUM VZW, 3001 Leuven (BE); Samsung Electronics Co., Ltd., Suwon-si, Gyeonggi-do 442-743 (KR); Taiwan Semiconductor Manufacturing Company, Ltd. (TSMC), Hsinchu 300-077 (TW)
(72) Inventor: Cho, Hag-Ju, Hwansung-city 445-738 (KR); Chang, Shih-Hsun, Hsinchu 300 (TW)
(74) Representative: Bird, William Edward

(57) **Abstract**

A simplified method of dual work function device manufacturing starting from a single metal electrode is described as well as the device itself.
A single-metal-single-dielectric (SMSD) CMOS integration scheme is described, where a single dielectric stack comprising a gate dielectric layer (1) and a dielectric capping layer (2) and one metal layer (3) overlying the dielectric stack are first deposited, forming a metal- dielectric interface. Upon forming the dielectric stack and the metal layer, at least part of the dielectric capping layer is selectively modified by adding work function tuning elements, the part being adjacent to the metal-dielectric interface.

## Description

### Field of the Invention

The present invention is related to dual work function devices and methods of their manufacture. Particularly, the invention is related to CMOS (complementary metal-oxide-semiconductor)-structures having a gate stack comprising a dielectric material and a metal gate material as well as methods of manufacturing these.

### Description of the Related Technology

Scaling MOSFET (metal-oxide-semiconductor field effect transistor) devices to improve performance results in higher gate leakage as the Si02 gate dielectric becomes thinner. To address this issue, Si02 gate dielectric has been replaced with high dielectric constant (high-k) materials (k-value > kSi02).

With the introduction of the high-k materials a new problems aroused at the interface between the polysilicon electrode and the high-k materials, e.g. the Fermi level pinning effect, causing high threshold voltages in MOSFET devices.

In the MOSFET device, the gate requires a threshold voltage (Vt) to render the channel conductive. Complementary MOS processes fabricate both n-channel and p-channel (NMOS and PMOS) transistors. The threshold voltage is influenced by what is called the work function difference.

The work function is a measure of the energy, in electron volts (eV), required to eject an electron in the material outside of a material atom to the vacuum, if the electron were initially at the Fermi level. The work function difference between the gate and the channel is essentially an arithmetic difference between the work function of the gate material closest to the channel region and the work function of the material of the channel region.

To establish threshold voltage (Vt) values, the work function differences of the respective PMOS and NMOS gate materials and their corresponding channel regions are independently established through channel processing and gate processing.

A known solution to Fermi level pinning effect is the introduction of metal gates. However, it has been proven difficult to identify band-edge metals (metals with either a n-type or a p-type work function) that are compatible with the conventional CMOS fabrication process.

Further, CMOS can be made using dual metal gates with single or dual dielectrics. In either case, a selective removal of one of the metal gates is necessary and adds substantial complexity and costs to the manufacturing process. Moreover removing selectively the metal gate material towards the underlying gate dielectric poses a risk of unavoidably damaging the gate dielectric during metal gate removal or introducing further complication of removing and re-depositing the gate dielectric.

### Certain Aspects and aims

An aim is to provide a method to fabricate a semiconductor device with a dual work function that solves at least one of the problems of the prior-art mentioned above, being at the same time manufacturing friendly and reliable.

One inventive aspect relates to a simplified method of dual work function device manufacturing starting from a single metal electrode and to the device itself.

Another inventive aspect relates to a method of dual work function device manufacturing which overcomes at least one of the drawbacks of prior art methods and to the device itself. Still another inventive aspect relates to a dual work function device with good performance and to the device itself.

### Summary of the invention

The present invention provides a method for manufacturing a dual work function semiconductor device having a substrate with a first region and a second region and a gate stack having an as deposited work function on the first region and the second region,, the method comprising: forming a gate dielectric layer overlying a first and a second region of a substrate, forming_{[GC1]} a dielectric capping layer overlying the gate dielectric layer, and forming a metal gate electrode overlying the dielectric capping layer, thereby forming a metal-dielectric interface; selectively introducing elements at least into part of the dielectric capping layer on the second region, the part being adjacent to the metal-dielectric interface, the elements being selected to modify the work function of the as deposited gate stack, and patterning simultaneously the gate stack on the first and the second region.

The method according to the above, wherein selectively introducing elements at least into part of the dielectric capping layer on the second region comprises performing an ion implantation or a plasma doping into the metal gate electrode and the dielectric capping layer with one or more elements on the second region, while the first region is protected with a mask layer.

The method according to the above, wherein selectively introducing elements at least into part of the dielectric capping layer on the second region comprises: performing an ion implantation or a plasma doping into the metal gate electrode with one or more elements on the second region, while the first region is protected with a mask layer; and subsequently performing a thermal treatment, thereby diffusing the elements at least into part of the dielectric capping layer on the second region, the part being adjacent to the metal-dielectric interface.

The method according to the above, wherein selectively introducing elements at least into part of the dielectric capping layer on the second region further comprises: depositing a material containing one or more elements overlying the metal gate electrode on the first and second region, the elements being selected to modify the work function of the as deposited gate stack; removing the material selectively from the first region; and performing a thermal treatment thereby diffusing the elements into the metal gate electrode and at least into part of the dielectric capping layer on the second region, the part being adjacent to the metal-dielectric interface..

The method according to any of the above, further comprising a nitridation of the metal gate electrode and the dielectric capping layer on the second region, while the first region is protected with a mask layer.

The method according to the above, further comprising a nitridation of the metal gate electrode or the dielectric capping layer on the second region, while the first region is protected with a mask layer.

The method according to any of the above, wherein the first region is a NMOS region and the second region is a PMOS region.

The method according to any of the above, wherein the elements are selected from the group consisting of Al, O, C, N, F and combinations thereof.

The method according to the above, wherein the elements comprise Al.

The method according to the above, wherein the material is selected from the group consisting of AlN, TiAlN, TaAlN, TaAlC and combinations thereof.

The method according to the above, wherein the first region is a PMOS region and the second region is a NMOS region.

The method according to the above, wherein the elements are selected from the group of lanthanides.

The method according to the above, wherein the thermal treatment is a spike anneal with the duration of 1s at 1030C.

The method according to the above, wherein the thermal treatment is performed at a temperature between 800-1050C for 1 minute.

The method according to any of the above, wherein the substrate can be a semiconductor material such as silicon, germanium, silicon on insulator (SOI), germanium on insulator (GeOI), III-V materials (GaAs, InP) or combinations thereof.

The method according to any of the above, wherein the gate dielectric comprises SiO₂, SiON, HfO₂, ZrO₂, La₂O₃, Dy₂O₃, Gd₂O₃ or combinations thereof.

The method according to the above, wherein the dielectric capping layer is a lanthanide based material, selected from the group consisting of La-, Gd-, Dy- oxides and La-, Gd-, Dy-silicates and combinations thereof.

The method according to the above, wherein the dielectric capping layer is a Al- based material, selected from the group consisting of Al- oxides and LaAl-oxides and silicates.

The method according to any of the above, wherein the metal gate electrode comprises a C-containing metal such as TaCx, TiCx, HfCx or a nitrided metal such as TaNx, TiNx, HfNx or combinations thereof, wherein x is a real number, 0< x ≤ 1.

The present invention also provides a dual work function semiconductor device comprising: a substrate comprising a first region and a second region; a first transistor on the first region comprising a first gate dielectric layer, a first dielectric capping layer and a first metal gate electrode and having a first (as-deposited) work function; and a second transistor on the second region comprising a second gate dielectric layer, a second dielectric capping layer and a second metal gate electrode and having a second work function wherein: the first gate dielectric and the second gate dielectric are made of the same material; the second dielectric capping layer is made of the same material with the first dielectric capping layer, further comprising one or more elements, the elements being selected to modify the first (as deposited) work function to obtain the second work function; and the second metal gate electrode is made of the same material with the first metal gate electrode, further comprising one or more elements, the elements being selected to modify the first (as deposited) work function to obtain the second work function.

The semiconductor device of the above, wherein the first transistor is a NMOS transistor and the second transistor is a PMOS transistor.

The semiconductor device of the above, wherein the first gate dielectric consists of HfSiON.

The semiconductor device of the above, wherein the first dielectric capping layer consists of lanthanum oxide (LaOx) or lanthanum oxinitride (LaNOx), wherein x is a real number 0<x≤1.

The semiconductor device of the above, wherein the element is Al.

The semiconductor device of the above, wherein the first metal gate electrode consists of Ta2C or TaxCyNz, with x, y, z being real numbers and x+y+z = 1.

Other inventive aspects are defined in the attached claims, in which each claim or alternative within a claim is a separate embodiment of the present invention.

### Brief Description of the Drawings

All drawings are intended to illustrate some aspects and embodiments of the present invention. The drawings described are only schematic and are non-limiting.

Fig. 1a represents schematically the selective implantation of the work function tuning element into the PMOS region of the gate stack according to an embodiment of the present invention.

Fig. 1b represents schematically the gate stack upon implantation of the work function tuning element and thermal treatment according to an embodiment of the present invention.

Fig. 2a represents the gate stack with the work function tuning element containing layer deposited upon and removed selectively from the NMOS region according to an embodiment of the present invention.

Fig. 2b represents the gate stack in Figure 2a, upon thermal treatment and diffusion of the work function tuning element into the underlying layers (metal electrode and dielectric capping layer) according to an embodiment of the present invention.

### Detailed Description of Certain Inventive Embodiments

The present invention will be described with respect to particular embodiments and with reference to certain drawings but the invention is not limited thereto but only by the claims. Any reference signs in the claims shall not be construed as limiting the scope. The drawings described are only schematic and are non-limiting. In the drawings, the size of some of the elements may be exaggerated and not drawn on scale for illustrative purposes.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

The terms deeper or higher are used to denote the relative position of elements in a substrate. With deeper is meant that these elements are more distant from a main surface of the substrate from which side the measurement is to be performed.

A major challenge of using high-k dielectrics in CMOS devices is the high value of the threshold voltage (Vt). Dual metal gates, optionally in combination with dual dielectrics can achieve lower Vt. However, these techniques usually involve multiple deposition and removal steps during the gate stack formation, adding additional costs to the current CMOS technology. Therefore, an easier, lower-cost CMOS integration is desired.

Where, herein, a specific chemical name or formula is given, the material may include non-stoichiometric variations of the stoichiometrically exact formula identified by the chemical name. Lack of numerical subscript by an element in the formula stoichiometrically signifies the number one (1). Variations in the range plus/minus 20% of the exact stoichiometric number are comprised in the chemical name or formula, for the present purposes. Where an algebraic subscript is given, then variations in the range plus/minus 20% are comprised relative to the value of each subscript. Such varied values do not necessarily sum to a whole number and this departure is contemplated. Such variations may occur due to either intended selection and control of the process conditions, or due to unintended process variations.

Various embodiments of the present invention include a single-metal-single-dielectric (SMSD) CMOS integration scheme, where a single dielectric stack comprising a gate dielectric layer and a dielectric capping layer and one metal layer overlying the dielectric stack are first deposited, forming a metal- dielectric interface. Upon forming the dielectric stack and the metal layer, at least part of the dielectric capping layer is selectively modified by adding work function tuning elements, the part being adjacent to the metal-dielectric interface.

An embodiment of the first aspect of the present invention provides a method for manufacturing a dual work function semiconductor device, comprising
(a) providing a substrate comprising a first region and a second region,
(b) forming a gate stack having an as deposited work function on the first region and the second region, comprising:
   (b1) forming a gate dielectric layer overlying the first and the second region
   (b2) forming a dielectric capping layer overlying the gate dielectric layer, and
   (b3) forming a metal gate electrode overlying the dielectric capping layer, thereby forming a metal-dielectric interface;
(c) selectively introducing elements at least into part of the dielectric capping layer on the second region, the part being adjacent to the metal-dielectric interface, the elements being selected to modify the work function of the as deposited gate stack, and
(d) patterning simultaneously the gate stack on the first and the second region.

An advantage of this embodiment of the current invention compared to the conventional integration scheme is that the integration route does not require selective metal etching, or selective dielectric capping layer etching, preserving in this way the metal-dielectric interface and avoiding the dielectric damage provoked by the selective etch.

Another advantage of this embodiment of the current invention is that a single metal integration route can be implemented and there is no need for a multi-metal gate stack to fabricate a dual work-function device. The single metal integration route allows patterning simultaneously the gate stack on the first and second region. Furthermore allows an easier optimization of the gate etching process, leading to a better gate stack profile. At the same time this embodiment of the method of the current invention reduces the number of steps (e.g. lithographic and etching steps) in manufacturing, reducing in this way the production cycle-time and the costs.

In one embodiment of the first aspect of the present invention, selectively introducing elements at least into part of the dielectric capping layer on the second region comprises performing an ion implantation or a plasma doping at least into part of the dielectric capping layer, or into the metal gate electrode and at least into part of the dielectric capping layer with one or more elements on the second region, while the first region is protected with a mask layer. The the part of the dielectric capping layer is adjacent to the metal-dielectric interface.

In an alternative embodiment of the first aspect of the present invention, selectively introducing elements at least into part of the dielectric capping layer on the second region comprises performing an ion implantation or a plasma doping into the metal gate electrode with one or more elements on the second region, while the first region is protected with a mask layer, followed by a thermal treatment, thereby diffusing the elements into at least into part of the dielectric capping layer on the second region, the part being adjacent to the metal-dielectric interface.

In one embodiment of the first aspect of the present invention, the first region is a NMOS region and the second region is a PMOS region. In this particular embodiment the elements are selected from the group of Al, O, C, N, F and combinations thereof. Preferably, the element is Al. Because of their functionality to modify the work function of the as deposited gate stack, these elements are also referred to as "work function tuning elements" throughout the text of the current patent application.

In another embodiment of the first aspect of the present invention, the method further comprises a nitridation of the metal gate electrode and/or the dielectric capping layer on the second region, while the first region is protected with a mask layer.

In an alternative embodiment of the first aspect of the present invention, selectively introducing elements at least into part of the dielectric capping layer on the second region further comprises
- depositing a material containing one or more elements overlying the metal gate electrode on the first and second region, the elements being selected to modify the work function of the as deposited gate stack,
- removing the material selectively from the first region, and
- performing a thermal treatment thereby diffusing the elements into the metal gate electrode and at least into part of the dielectric capping layer on the second region, the part being adjacent to the metal-dielectric interface.

In a particular embodiment of the first aspect of the present invention, the first region is a NMOS region and the second region is a PMOS region and the material comprises Al. Preferably, the material is selected from the group of AlN, TiAlN, TaAlN, TaAlC and combinations thereof. More preferably the material comprises TiAlN.

Preferably, the thermal treatment is performed at a temperature between 800-1050°C for 1 minute. More preferably the thermal treatment is a spike anneal of 1s at 1030°C.

The substrate is a semiconductor material such as silicon, germanium, silicon on insulator (SOI), germanium on insulator (GeOI), III-V materials (GaAs, InP) or combinations thereof.

The gate dielectric can be selected from the group of SiO₂, SiON, HfO₂, ZrO₂, La₂O₃, Dy₂O₃, Gd₂O₃, and combinations thereof.

In the embodiment wherein the first region is a NMOS region and the second region is a PMOS region, the dielectric capping layer is a lanthanide-based high-k dielectric material. More preferably, the dielectric capping layer can be selected from the group of La-, Gd-, Dy- oxides, La-, Gd-, Dy-silicates and combinations thereof.

In an alternative embodiment, wherein first region is a PMOS region and second region is an NMOS region, the dielectric capping layer is a Al-based high-k dielectric material. More preferably, the dielectric capping layer can be selected from the group of Al₂O₃, LaAlO₃ and their silicates. In this alternative embodiment the work function tuning elements can be selected from the group of lanthanides (e.g. La, Dy, Gd).

The metal gate electrode comprises a C-containing metal such as TaCx, TiCx, HfCx or a nitrided metal such as TaNx, TiNx, HfNx or combinations thereof, wherein x is a real number and 0<x ≤1.

An embodiment of the second aspect of the present invention provides a dual work function semiconductor device comprising a substrate comprising a first region and a second region, a first transistor on the first region comprising a first gate dielectric layer, a first dielectric capping layer and a first metal gate electrode having a first (as-deposited) work function, and a second transistor on the second region comprising a second gate dielectric layer, a second dielectric capping layer and a second metal gate electrode having a second work function, wherein the first gate dielectric and the second gate dielectric are made of the same material, the second dielectric capping layer is made of the same material with the first dielectric capping layer, further comprising one or more elements, the elements being selected to modify the first (as deposited) work function to obtain the second work function, and the second metal gate electrode is made of the same material with the first metal gate electrode, further comprising one or more elements, the elements being selected to modify the first (as deposited) work function to obtain the second work function. Furthermore, the first gate dielectric layer and the second gate dielectric layer have the same thickness. Advantageously, the first dielectric capping layer and the second dielectric capping layer have the same thickness. Preferably, the first metal gate electrode and the second metal gate electrode have the same thickness.

In one embodiment of the second aspect of the present invention, the first transistor is a NMOS transistor and the second transistor is a PMOS transistor.

In one specific embodiment of the second aspect of the present invention, the first gate dielectric and the second gate dielectric comprises HfSiON, the first dielectric capping layer comprises LaOx or LaNOx, with 0<x ≤1, the work function tuning (modifying) element is Al and the first metal gate electrode comprises Ta₂C or TaxCyNz, with x, y, z being real numbers and x+y+z = 1.

Further an example is disclosed in more detail. The work function of Ta₂C depends on the high-k material used as gate dielectric, i.e. it is about 4.3 eV, when it is in contact with HfO₂ and about 4.6 eV, when in contact with HfSiON. In order to compensate the relatively high work function on HfSiON, various capping layers with thicknesses less than 1.5nm have been tested. Among them, LaOx shows a large shift of the work function of considered metal gate toward NMOS band edge. For example, the work function of Ta₂C turned out to be 3.9 eV with the capping layer of 1 nm thick LaOx on HfSiON.

To implement this interesting result in CMOS integration, a solution has to be find for defining PMOS gate at the same time with the NMOS, using a single metal integration scheme.

A known solution would be to remove LaOx on PMOS area selectively, but this has several drawbacks, e.g.
(1) it is an expensive integration route with additional process step involving patterning and selective removal;
(2) can have poor selectivity towards the gate dielectric
(3) the selective removal can modify the interface between the gate dielectric and the metal electrode, with unwanted shifts on the final work function and final equivalent oxide thickness (EOT).

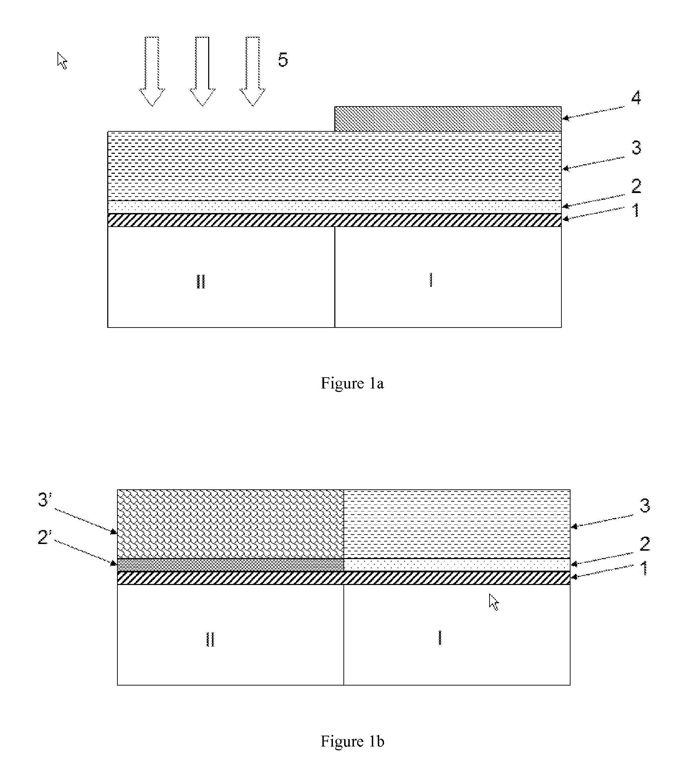

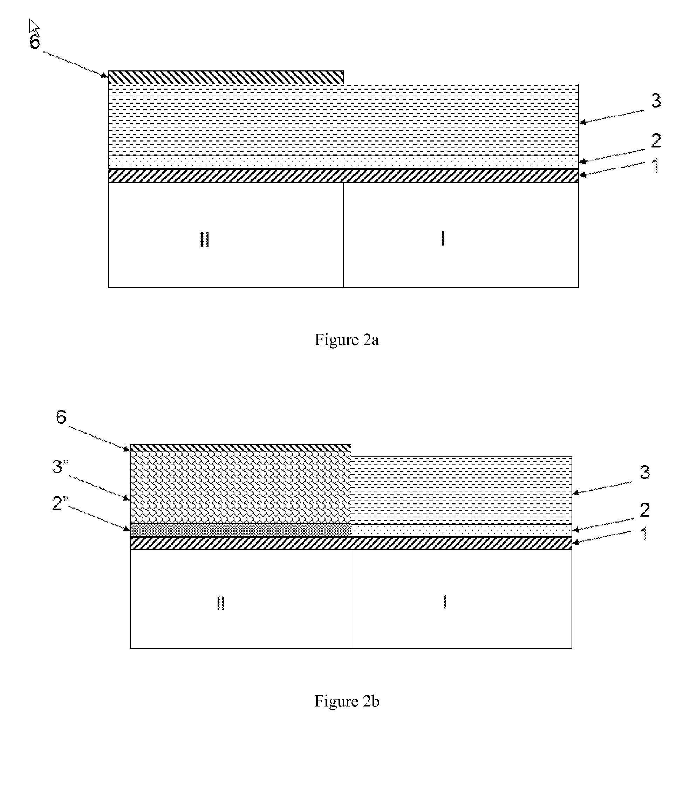

Further, 3 examples are in detail described. They are schematically represented in Figure 1(a,b) and Figure 2(a,b). Each example discloses a gate stack containing a gate dielectric (1), a dielectric capping layer (2) and a metal gate electrode (3).

The gate stack is deposited on a semiconductor substrate comprising two regions (I, II). First region (I) is a NMOS region and second region (II) is a PMOS region. The gate dielectric (1) can be selected from the group of SiO₂, SiON, HfO₂, ZrO₂, La₂O₃, Dy₂O₃, Gd₂O₃, and combinations thereof. The dielectric capping layer (2) can comprise a lanthanide- based material. Preferably the dielectric capping layer can be selected from the group of La-, Gd-, Dy- oxides, La-, Gd, Dy-silicates and combinations thereof.

In an alternative embodiment wherein first region (I) is a PMOS region and second region (II) is a NMOS region the dielectric capping layer (2) can comprise aluminum. Preferably the dielectric capping layer can be selected from the group of Al₂O₃, LaAlO₃ and their silicates.

Metal electrode (3) can comprise a metal (e.g. Ta, W), a C-containing metal such as TaCx, TiCx, HfCx or a nitrided metal such as TaNx, TiNx, HfNx or combinations thereof, wherein x is a real number 0<x≤1. Preferably the metal electrode can be any metal, C-containing metal or nitrided metal showing a NMOS work function.

In a first example, schematically represented in Fig 1(a, b), upon deposition of the gate stack, a work function tuning element (5) implantation is performed only in the PMOS area (II). A photoresist mask layer (4) can be used to perform this implantation selectively. Upon implantation the photoresist (4) is removed selectively towards the underlying layers.

The work function tuning element can be selected from the group of Al, O, C, N, F and combinations thereof. Upon implantation, the gate stack undergoes a thermal treatment, e.g. typically 1 minute at 950°C or a spike anneal (with a duration of 1s) at 1030°C. As a result of the implantation and the thermal treatment, a modified metal gate electrode material (3') and at least a partially modified dielectric capping layer (2') is formed (Figure 1, b). Preferably the capping layer (2') is thoroughly modified, up to the interface with the gate dielectric (1).

In a specific embodiment, HfSiOx is employed as gate dielectric (1), LaOx as dielectric capping layer (2), Ta₂C as metal gate electrode (3) and Al as work function tuning element(5). In this specific embodiment, the modified gate electrode (3') comprises TaxAlyCz and the modified dielectric capping layer (2') comprises LaxAylOz, wherein x, y, z are in both cases real numbers between 0 and 1 and x+y+z = 1.

In second example, N can be added in a percentage typically from 10at% to 40 at% to the metal gate electrode either and/or to the dielectric capping layer, before or after the work function tuning element implantation. Adding N to the metal gate electrode and/or to the dielectric capping layer can be done either by plasma nitridation or by N implantation. The N implantation can be done either simultaneously with the implantation of the work function tuning element or sequentially.

In a third example the gate stack (dielectric stack and metal electrode) deposition is followed by the deposition of a layer containing a work function tuning element (6) and its selective removal from the NMOS region (I) (Figure 2a). Upon deposition and selective removal, a thermal treatment will allow the diffusion of the work function tuning element(s) into the metal electrode (3) and at least partially in the dielectric capping layer (2), forming a modified metal electrode (3") and at least a partially modified dielectric capping layer (2") (Figure 2b).

In another specific embodiment of the first aspect of the present invention, the layer containing a work function element can be selected from the group of AlN, TiAlN, TaAlN, TaAlC and combinations thereof. More preferably the layer containing a work function element comprises TiAlN. In this preferred embodiment, the modified gate electrode (3") comprises an alloy of Ta₂C with TiAlN and the modified dielectric capping layer (2") comprise LaxAylOz, with x, y, z being real numbers between 0 and 1 and x+y+z = 1.

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. A method for manufacturing a dual work function semiconductor device having a substrate with a first region and a second region and a gate stack having an as deposited work function on the first region and the second region, the method comprising:
forming a gate dielectric layer overlying a first and a second region of a substrate, forming a dielectric capping layer overlying the gate dielectric layer, and forming a metal gate electrode overlying the dielectric capping layer, thereby forming a metal-dielectric interface; selectively introducing elements at least into part of the dielectric capping layer on the second region, the part being adjacent to the metal-dielectric interface, the elements being selected to modify the work function of the as deposited gate stack, and patterning simultaneously the gate stack on the first and the second region.

2. The method according to claim 1, wherein selectively introducing elements at least into part of the dielectric capping layer on the second region comprises performing an ion implantation or a plasma doping into the metal gate electrode and the dielectric capping layer with one or more elements on the second region, while the first region is protected with a mask layer.

3. The method according to claim 1, wherein selectively introducing elements at least into part of the dielectric capping layer on the second region further comprises: depositing a material containing one or more elements overlying the metal gate electrode on the first and second region, the elements being selected to modify the work function of the as deposited gate stack; removing the material selectively from the first region; and performing a thermal treatment thereby diffusing the elements into the metal gate electrode and at least into part of the dielectric capping layer on the second region, the part being adjacent to the metal-dielectric interface..

4. The method according to any of the previous claims, wherein the first region is a NMOS region and the second region is a PMOS region.

5. The method according to any of the previous claims, wherein the elements are selected from the group consisting of Al, O, C, N, F and combinations thereof.

6. The method according to any of the previous claims, wherein the dielectric capping layer is a lanthanide based material, selected from the group consisting of La-, Gd-, Dy- oxides and La-, Gd-, Dy-silicates and combinations thereof

7. The method according to any of the previous claims, wherein the material is selected from the group consisting of AlN, TiAlN, TaAlN, TaAlC and combinations thereof.

8. The method according to any of the claims 1 to 3, wherein the first region is a PMOS region and the second region is a NMOS region.

9. The method according to claim 7, wherein said elements are selected from the group of lanthanides.

10. The method according to any of the claims 7 or 8, wherein the dielectric capping layer is an Al- based material, selected from the group consisting of Al- oxides and LaAl-oxides and silicates.

11. A dual work function semiconductor device comprising: a substrate comprising a first region and a second region; a first transistor on the first region comprising a first gate dielectric layer, a first dielectric capping layer and a first metal gate electrode and having a first (as-deposited) work function; and a second transistor on the second region comprising a second gate dielectric layer, a second dielectric capping layer and a second metal gate electrode and having a second work function Wherein: the first gate dielectric and the second gate dielectric are made of the same material; the second dielectric capping layer is made of the same material with the first dielectric capping layer, further comprising one or more elements, the elements being selected to modify the first (as deposited) work function to obtain the second work function; and the second metal gate electrode is made of the same material with the first metal gate electrode, further comprising one or more elements, the elements being selected to modify the first (as deposited) work function to obtain the second work function.

12. The semiconductor device of claim 11 wherein the first gate dielectric consists of HfSiON.

13. The semiconductor device of claim 11 or 12, wherein the first dielectric capping layer consists of lanthanum oxide (LaOx) or lanthanum oxinitride (LaNOx), wherein x is a real number 0<x≤1.

14. The semiconductor device of any of the claims 11 to 13, wherein the element is selected from the group consisting of Al, O, C, N, F and combinations thereof.

15. The semiconductor device of any of the claims 11 to 14, wherein the first metal gate electrode consists of Ta2C or TaxCyNz, with x, y, z being real numbers and x+y+z = 1.
